# EUROPEAN PATENT APPLICATION

(11) **EP 4 610 086 A1**
(43) Date of publication of application: **03.09.2025**
(21) Application number: 25153645.4
(22) Date of filing: 23.01.2025
(51) Int. Cl.: B60L 3/00, B60K 11/02, B60L 53/24, H02J 7/02

(54) **ELECTRIC VEHICLE**

(30) Priority: 09.02.2024 JP 2024018983
(71) Applicant: TOYOTA JIDOSHA KABUSHIKI KAISHA, Aichi-ken, 471-8571 (JP)
(72) Inventor: TSURUMI, Yukinori, Toyota-shi, 471-8571 (JP); DEGUCHI, Junichi, Toyota-shi, 471-8571 (JP); IRAHA, Taira, Toyota-shi, 471-8571 (JP); ISHIURA, Kazuaki, Toyota-shi, 471-8571 (JP); AWATA, Hideya, Toyota-shi, 471-8571 (JP); NAKAGAWA, Hideki, Toyota-shi, 471-8571 (JP); SHIBATA, Ryosuke, Toyota-shi, 471-8571 (JP); NAGAI, Takaya, Toyota-shi, 471-8571 (JP)
(74) Representative: D Young & Co LLP

(57) **Abstract**

The present teachings provide an electric vehicle (100) configured to cool an electric motor (110) when it is likely that the electric motor is to be used immediately after neutral point charging. The electric vehicle may include: an electric motor (110) configured to drive an axle; an inverter (120) including a DC terminal connected to a battery (109) and AC terminals connected to stator coils (111) of the electric motor; a charging terminal (103) connected to a neutral point of the stator coils; a cooler (130) configured to cool the electric motor; and a controller (101). The controller may activate the cooler when a main switch (102) for activating the electric motor is on and a temperature of the motor exceeds a threshold temperature after the controller has boosted electric power supplied through the charging terminal with the stator coils and the inverter and charged the battery.

## Description

### CROSS-REFERENCE TO RELATED APPLICATION(S)

This application claims priority to Japanese Patent Application No. 2024-018983 filed on February 9, 2024, the contents of which are hereby incorporated by reference into the present application.

### TECHNICAL FIELD

The present application relates to an electric vehicle comprising a battery and an electric motor configured to drive an axle.

### BACKGROUND ART

It is known that a circuit composed of stator coils of an electric motor and a switching device of an inverter can be utilized as a boost converter. Japanese Patent Application Publication No. 2009-118659 describes a technique of connecting a power supply to a neutral point of stator coils and boosting a voltage of the power supply by a circuit including the stator coils and the inverter so as to charge a battery. Hereafter, for convenience of description, charging of a battery by connecting a power supply to a neutral point of stator coils and boosting a voltage of the power supply with a circuit including the stator coils and an inverter will be referred to as "neutral point charging".

### SUMMARY

A temperature of the electric motor rises when the neutral point charging is being carried out. If the electric motor is not to be driven immediately after the neutral point charging, the electric motor does not need to be cooled even when the temperature of the electric motor is high. Contrary to this, if the electric motor is likely to be used immediately after the neutral point charging, the electric motor should be cooled after the charging. The present teachings provide an electric vehicle configured to cool an electric motor when the electric motor is likely to be used immediately after neutral point charging.

An electric vehicle disclosed herein may comprise: an electric motor configured to drive an axle; an inverter; a charging terminal connected to a neutral point of stator coils of the electric motor; a cooler configured to cool the electric motor; and a controller. The inverter comprises a DC terminal connected to a battery and AC terminals connected to the stator coils of the electric motor.

The controller may activate the cooler when a main switch for activating the electric motor is on and a temperature of the motor exceeds a threshold temperature after the controller has boosted electric power supplied through the charging terminal with the stator coils and the inverter and charged the battery. Even when the temperature of the electric motor exceeds the threshold temperature after the controller has boosted electric power supplied through the charging terminal with the stator coils and the inverter and charged the battery, the controller does not activate the cooler if the main switch is off. The electric vehicle disclosed herein activates the cooler when it is likely that the electric motor is to be used after the neutral point charging.

Details of the art disclosed herein and further developments will be described in DESCRIPTION.

### BRIEF DESCRIPTION OF DRAWINGS

FIG. 1 illustrates a block diagram of an electric vehicle 100 according to a first embodiment.
FIG. 2 illustrates a block diagram of an electric vehicle 200 according to a second embodiment.
FIG. 3 illustrates a block diagram of an electric vehicle 300 according to a third embodiment.
FIG. 4 illustrates a structure of a drive 500 in which a motor case and a gear case are coupled.

### DESCRIPTION

### (First Embodiment)

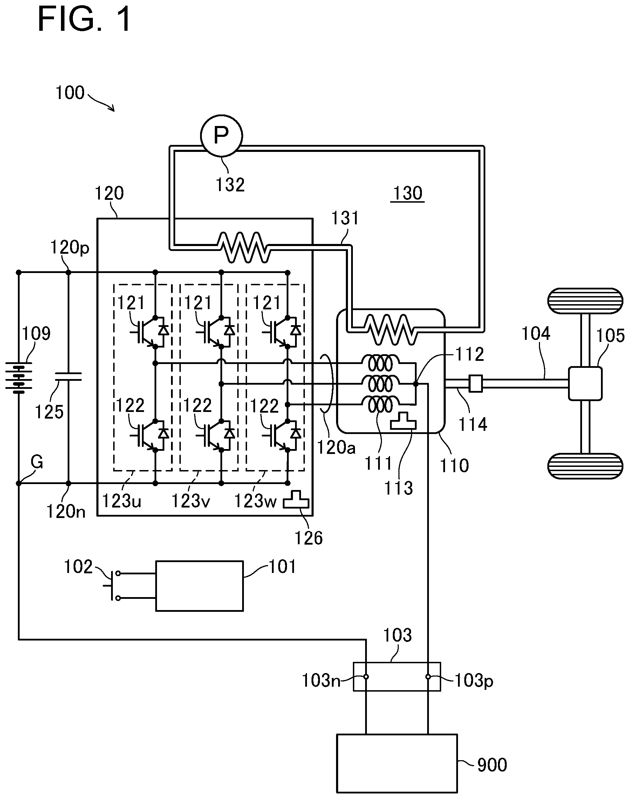

FIG. 1 illustrates a block diagram of an electric vehicle 100 according to a first embodiment. The electric vehicle 100 comprises an electric motor 110, an inverter 120, a battery 109, a cooler 130, a controller 101, and a charging terminal 103. Hereafter, for convenience of description, the electric motor 110 may be referred to as simply a motor 110.

A main shaft 114 of the motor 110 is coupled to an axle 104, and the axle 104 is coupled to wheels via differential gears 105. The motor 110 is a three-phase AC motor, and comprises three stator coils 111. The motor 110 drives the axle 104, and thus the electric vehicle 100 travels.

The inverter 120 converts DC power of the battery 109 to AC power suitable for driving the motor 110. DC terminals 120p, 120n of the inverter 120 are connected to the battery 109, and AC terminals 120a of the inverter 120 are connected to the motor 110. More specifically, each of the plurality of AC terminals 120a of the inverter 120 is connected to corresponding one of the plurality of stator coils 111 of the motor 110. A capacitor 125 is connected between the positive terminal 120p and the negative terminal 120n of the DC terminals. A negative terminal of the battery 109 and the negative terminal 120n of the inverter 120 are held at a same potential. The negative terminal of the battery 109 is referred to as a ground G.

The inverter 120 comprises three series connection circuits 123u, 123v, 123w. The three series connection circuits 123u, 123v, 123w will be collectively referred to as series connection circuits 123. The three series connection circuits 123 are connected in parallel to each other between the positive terminal 120p and the negative terminal 120n of the DC terminals. Each of the series connection circuits 123 is composed of a series connection of two switching elements (upper switching element 121 and lower switching element 122). A diode is connected antiparallel to each of the switching elements. The diode allows current to pass from a lower potential side to a higher potential side of the switching element. The diode may be incorporated in the switching element. When the controller 101 switches alternately the upper switching element 121 and the lower switching element 122 on and off, alternate current is output from a middle point of each of the series connection circuits 123. Circuit configurations and operation of the inverter 120 are well-known, and thus detailed description thereof will be omitted.

The cooler 130 cools the inverter 120 and the motor 110. The cooler 130 comprises a circulation path 131 and a pump 132. When the pump 132 operates, refrigerant circulates in the circulation path 131. The circulation path 131 passes inside the inverter 120 and the motor 110, and the refrigerant flowing in the circulation path 131 cools the inverter 120 and the motor 110. Although not shown, the circulation path 131 also comprises a reserve tank and a radiator. The reserve tank is arranged in the circulation path 131 on an upstream side of the pump 132, and the radiator is disposed in the circulation path 131 on the upstream side of the reserve tank. The refrigerant having absorbed heat of the inverter 120 and of the motor 110 is cooled by the radiator and returns to the reserve tank. The pump 132 pumps the refrigerant in the reserve tank toward the inverter 120 and the motor 110.

The motor 110, the inverter 120 (switching elements 121, 122), and the cooler 130 are controlled by the controller 101. A main switch 102 is connected to the controller 101. The main switch 102 is also called an ignition switch. The main switch 102 is disposed at a driver's seat, and a user operates the switch 102. The main switch 102 is a switch for driving the electric motor 110. When the main switch 102 is on, the electric vehicle 100 is in a state of being able to travel. When the main switch 102 is off, the controller 101 does not allow the electric vehicle 100 to travel. In other words, when the main switch 102 is off, the controller 101 prohibits the motor 110 from rotating. When the main switch 102 is on, the controller 101 allows the motor 110 to rotate.

The cooler 130 may comprise an auxiliary cooler which uses oil as refrigerant. The auxiliary cooler comprises an oil circulation path, an oil cooler, and an oil pump. The oil circulation path passes through the oil cooler and the motor 110. The oil pump circulates the oil between the oil cooler and the motor 110. The refrigerant in the circulation path 131 cools the oil with the oil cooler, and the oil cools the motor 110. The oil may be directly poured over a stator and a rotor of the motor 110. In this case, the oil also serves as a lubricant.

One end of each of the plurality of stator coils 111 of the motor 110 is connected to corresponding one of the plurality of AC terminals 120a of the inverter 120, and other ends of the plurality of stator coils 111 are connected to each other. A point at which the other ends of the stator coils 111 are connected is called a neutral point 112.

A positive terminal 103p of the charging terminal 103 is connected to the neutral point 112. A negative terminal 103n of the charging terminal 103 is connected to the ground G. The electric vehicle 100 is configured to have the charging terminal 103 connected to an external power supply 900 and charge the battery 109 with the power supply 900. A circuit configuration of the stator coils 111 and the lower switching elements 122 serves as a boost converter. That is, the power supply 900 having a lower output voltage than the battery 109 can charge the battery 109. Charging via the neutral point is referred to as neutral point charging in the present teachings.

The neutral point charging will be generally described. A DC voltage of the power supply 900 is applied to the neutral point 112. When the lower switching elements are turned on, current starts to flow in the stator coils 111 and magnetic energy is accumulated there. When the lower switching elements are turned off, the voltage of the AC terminals 120a is pushed up by the magnetic energy accumulated in the stator coils 111. That is, the voltage of the power supply 900 is boosted.

Even with the main switch 102 in the off state, the controller 101 can perform the neutral point charging. As mentioned above, when the main switch 102 is off, the controller 101 prohibits the motor 110 from rotating. When performing the neutral point charging, the controller 101 drives the lower switching elements 122 so as not to rotate the motor 110, and boosts the voltage applied on the neutral point 112.

The neutral point charging is performed while the electric vehicle 100 stops. When the neutral point charging is performed, the stator coils 111 of the motor 110 and the lower switching elements 122 of the inverter 120 generate heat. The motor 110 includes a temperature sensor 113 and the inverter 120 also includes a temperature sensor 126, and measurement data of the temperature sensors 113, 126 is sent to the controller 101.

The controller 101 activates the cooler 130 when the main switch 102 is on and also the temperature of the motor 110 exceeds a threshold temperature after the controller 101 has boosted power supplied through the charging terminal 103 with the stator coils 111 and the inverter 120 and charged the battery 108 (that is, after the neutral point charging). This is because, when the main switch 102 is on, it is likely that the user will have the electric vehicle 100 travel after the neutral point charging has finished. It is desirable that the temperature of the motor 110 is immediately decreased in such cases. As mentioned above, the cooler 130 also cools the inverter 120 as well as the motor 110.

After the neutral point charging, if the main switch 102 is off, the controller 102 does not activate the cooler 130 even when the temperature of the motor 110 exceeds the threshold temperature. When the main switch 102 is off, it is less likely that the user will immediately have the electric vehicle 100 travel. In such cases, energy for operating the cooler 130 can be saved by leaving the motor 110 (and the inverter 120) to be naturally cooled. After the neutral point charging, even when the main switch 102 is on, the controller 101 does not activate the cooler 130 if the temperature of the motor 110 is lower than the threshold temperature.

When the temperature of the motor 110 exceeds an upper limit temperature, the controller 101 cools the motor 110 irrespective of the state of the main switch 102 in order to protect the motor 110 from being heated. The upper limit temperature is set to a value higher than the above-mentioned threshold temperature. When the temperature of the motor 110 exceeds the upper limit temperature in the middle of the neutral point charging, the controller 101 cools the motor 110.

### (Second Embodiment)

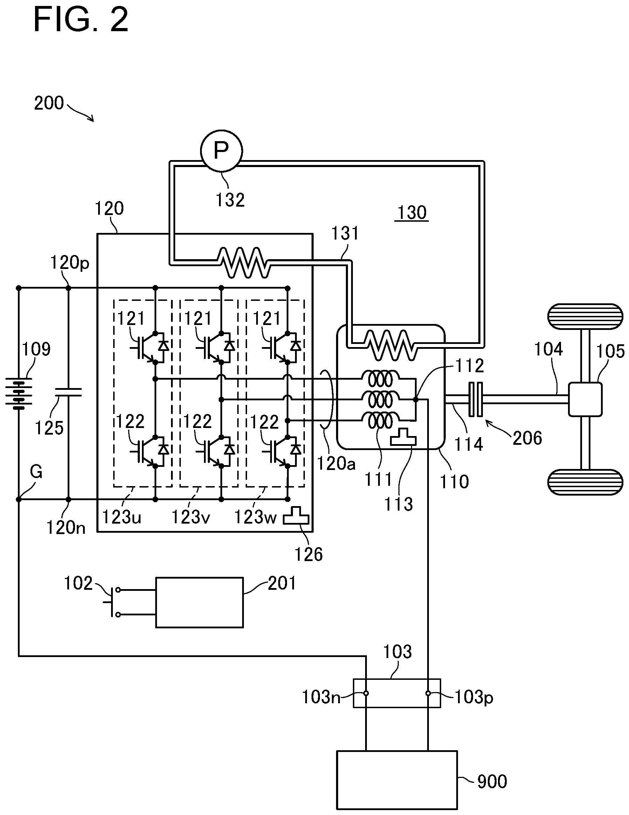

FIG. 2 illustrates a block diagram of an electric vehicle 200 according to a second embodiment. The electric vehicle 200 according to the second embodiment comprises a clutch 206 between the motor 110 and the axle 104. The clutch 206 is configured to have the motor 110 engage with the axle 104 and disengage the motor 110 from the axle 104. The other configurations of the electric vehicle 200 are the same as those of the electric vehicle 100 according to the first embodiment. Processes of the controller after the neutral point charging are however different between the electric vehicle 100 and the electric vehicle 200. Accordingly, a sign 201 is used for the controller of the electric vehicle 200.

The electric vehicle 200 is configured to charge the battery 109 by the neutral point charging in the same way as the electric vehicle 100 does. If the clutch 206 is not engaged, the controller 201 does not activate the cooler 130 even when the main switch 102 is on and the temperature of the motor 110 exceeds the threshold temperature. In other words, if the motor 110 disengages from the axle 104, the controller 201 does not activate the cooler 130 even when the main switch 102 is on and the temperature of the motor 110 exceeds the threshold temperature after the neutral point charging. When the motor 110 disengages from the axle 104, it is less likely that the user will have the electric vehicle 200 travel immediately after the neutral point charging. In such cases, the motor 110 and the inverter 120 of which temperatures have been increased after the neutral point charging may be left to natural cooling.

The controller 201 activates the cooler 130 when the main switch 102 is on, the temperature of the motor 110 exceeds the threshold temperature, and the motor 110 is engaged with the axle 104 after the neutral point charging. If the main switch 102 is off after the neutral point charging, the controller 201 does not activate the cooler 130.

### (Third Embodiment)

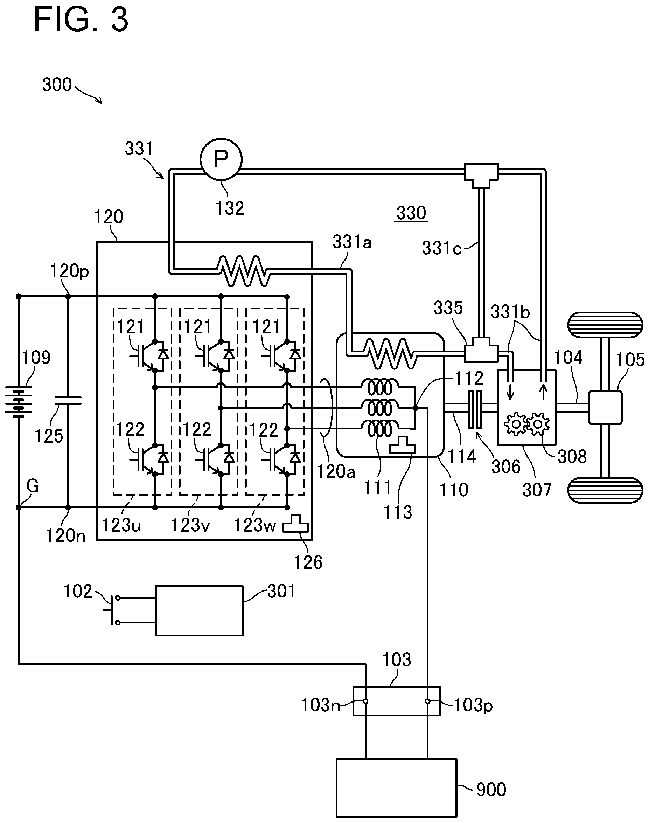

FIG. 3 illustrates a block diagram of an electric vehicle 300 according to a third embodiment. The electric vehicle 300 differs from the electric vehicle 100 according to the first embodiment about a cooler 330 and a controller 301. The electric vehicle 300 differs from the electric vehicle 100 also in that the electric vehicle 300 comprises a clutch 306 and a gear case 307.

Gears 308 are accommodated in the gear case 307. In the figure, the gears 308 are schematically shown. The main shaft 114 of the motor 110 engages with the gears 308 via the clutch 306. The clutch 306 is configured to couple the motor 110 to the gears 308 and disengage the motor 110 from the gears 308. The gears 308 engage with the axle 104. Torque of the motor 110 actuates the axle 104 via the clutch 306 and the gears 308. When the clutch 306 is separated, the gears 308 and the axle 104 do not rotate even when the motor 110 rotates.

A circulation path 331 of the cooler 330 includes an upstream path 331a, a downstream path 331b, and a bypass path 331c. The upstream path 331a, the downstream path 331b, and the bypass path 331c are coupled by a three-way valve 335. The three-way valve 335 connects the upstream path 331a to one of the downstream path 331b and the bypass path 331c, and disengages the same from the other of the downstream path 331b and the bypass path 331c. The downstream path 331b passes through the gear case 307 and the bypass path 331c bypasses the gear case 307. Downstream ends of the downstream path 331b and the bypass path 331c are both connected to the pump 132. Similar to the cooler 130 of the electric vehicle 100 according to the first embodiment, the cooler 330 also comprises an unillustrated reserve tank and an unillustrated radiator.

When the upstream path 331a is connected to the downstream path 331b, the refrigerant having passed through the inverter 120 and the motor 110 is fed to the gear case 307. In the gear case 307, the refrigerant is poured over the gears 308. The refrigerant also serves as a lubricant for the gears 308.

When the upstream path 331a is connected to the bypass path 331c, the refrigerant having passed through the inverter 120 and the motor 110 bypasses the gear case 307 and returns to the pump 132.

Hereafter, a state in which the upstream path 331a is connected to the downstream path 331b such that the refrigerant is supplied to the inverter 120, the motor 110, and the gears 308 will be referred as a full circulation mode. A state in which the upstream path 331a is connected to the bypass path 331c such that the refrigerant is supplied to the inverter 120 and the motor 110 but not supplied to the gears 308 will be referred to as a half circulation mode. When activating the cooler 330, the controller 301 selects one of the full circulation mode and the half circulation mode.

Similar to the cooler 130, the cooler 330 may comprise an auxiliary cooler which uses oil as refrigerant. The auxiliary cooler comprises an oil circulation path, an oil cooler, and an oil pump. The oil circulation path passes through the oil cooler, the motor 110, and the gear case 307. The oil pump circulates the oil between the oil cooler, the motor 110, and the gear case 307. The refrigerant of the circulation path 331 cools the oil with the oil cooler, and the oil cools the motor 110 and the gears 308. The oil directly contacts the gears. The oil may directly contact the stator and the rotor of the motor 110. In this case, the oil also serves as a lubricant for the motor 110 and the gears 308.

The electric vehicle 300 comprises the gears 308. The gears 308 are arranged between the axle 104 and the motor 110, and increase the torque of the motor 110 and transmits the same to the axle 104. The refrigerant of the cooler 330 also serves as a lubricant for the gears 308. The clutch 306 is arranged between the motor 110 and the gears 308, and the clutch 306 is configured to have the gears 308 engage with the motor 110 and disengage the gears 308 from the motor 110. The cooler 330 comprises a selector (the three-way valve 335) configured to select one of the full circulation mode in which the cooler 330 supplies the refrigerant to both the motor 110 and the gears 308 and the half circulation mode in which the cooler 330 supplies the refrigerant to the motor 110 but does not supply to the gears 308. While the controller 301 is cooling the motor 110, the controller 301 activates the cooler 330 in the full circulation mode when the motor 110 engages with the gears 308. The controller 301 activates the cooler 330 in the half circulation mode when the motor 110 disengages from the gears 308.

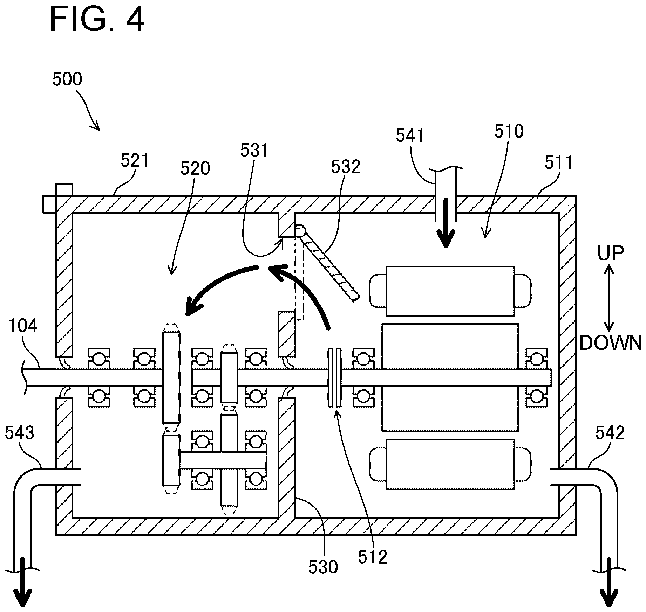

An example of a structure configured to select between the full circulation mode and the half circulation mode without using a three-way valve is shown in FIG. 4. FIG. 4 shows a structure of a drive 500 in which a motor case 511 and a gear case 521 are coupled. In the drive 500, the motor case 511 and the gear case 521 are coupled and are partitioned from each other by a bulkhead 530. A motor 510 is accommodated in the motor case 511 and a plurality of gears 520 is accommodated in the gear case 521. A main shaft of the motor 510 and the gears 520 are engaged via a clutch 512. When the clutch 512 is linked, the motor 510 and the gears 520 engage with each other, by which the gears 520 and the axle 104 rotate along with the motor 510. When the clutch 512 is separated, the motor 510 separates from the gears 520. An output axis of the gears 520 corresponds to the axle 104. An oil supply tube 541 is connected to a top part of the motor case 511, and the oil is supplied from the oil supply tube 541. The oil is poured over the motor 510. The oil cools the motor 510 and also lubricates the motor 510.

The bulkhead 530 comprises a communication hole 531 and a movable plate 532 configured to close the communication hole 531. The movable plate 532 is controlled by a controller (not shown). FIG. 4 shows a state in which the movable plate 532 is opened. When the movable plate 532 is open, the motor case 511 and the gear case 521 are connected through the communication hole 531. Virtual lines in FIG. 4 show a state in which the movable plate 532 is closed. When the movable plate 532 is closed, the communication hole 531 is capped, by which a space inside the motor case 511 and a space inside the gear case 521 are divided.

When the motor 510 rotates with the movable plate 532 being open, a part of the oil whirled upward by the rotation of the motor 510 enters the gear case 521 through the communication hole 531. The oil entering the gear case 521 is poured over the gears 520. The oil cools and also lubricates the gears 520. Bold arrows in FIG. 4 show flows of the oil when the movable plate 532 is open. When the movable plate 532 is closed, the oil of the motor case 511 does not enter the gear case 521.

An oil discharge tube 542 is connected to a bottom part of the motor case 511, and an oil discharge tube 543 is connected to a bottom part of the gear case 521. The oil accumulating in the bottom part of the motor case 511 is discharged from the oil discharge tube 542 and the oil accumulating in the bottom part of the gear case 521 is discharged from the oil discharge tube 543.

The oil supply tube 541 and the oil discharge tubes 542, 543 are a part of the cooler. When the unillustrated controller activates the cooler with the movable plate 532 closed, the above-mentioned half circulation mode is enabled, and when the unillustrated controller activates the cooler with the movable plate 532 open, the full circulation mode is enabled. The movable plate 532 corresponds to the selector configured to select one of the full circulation mode in which the refrigerant is supplied to both the motor and the gears and the half circulation mode in which the refrigerant is supplied to the motor but not supplied to the gears.

Some of points to be noted regarding the art described in the embodiments will be listed. Each of the electric vehicles 100, 200, and 300 may be configured to cool the motor when it is likely that the motor will be used immediately after the neutral point charging. The controller does not activate the cooler if the main switch 102 is off even when the temperature of the motor exceeds the threshold temperature after the neutral point charging.

The main switch 102 is a switch for driving the motor 110. However, even when the main switch 102 is off, it is possible to perform the neutral point charging. In the neutral point charging, current flows in the stator coils 111 of the motor 110 but the motor 110 does not rotate. More precisely speaking, the main switch 102 is a switch for allowing the motor 110 to be rotationally driven. When the main switch 102 is on, the motor 110 is allowed to be rotationally driven, and when the main switch 102 is off, the motor 110 is prohibited from being rotationally driven.

The electric vehicle 200 of the embodiment comprises the clutch 206 as a mechanism configured to have the motor and the axle engage with each other and disengage from each other. The electric vehicle 300 of the embodiment comprises the clutch 306 as a mechanism configured to have the motor and the gears engage with each other and disengage from each other. The mechanism configured to have the motor and the axle (or gears) engage with each other and disengage from each other may be a disconnect mechanism which implements a ball screw. Any mechanism may be implemented as the mechanism configured to have the motor and the axle (or gears) engage with each other and disengage from each other.

"Electric vehicle" disclosed herein may encompass a hybrid vehicle comprising both an electric motor and an engine and a fuel cell vehicle comprising a battery and a fuel cell. For example, a type of the vehicle in which one of front wheels and rear wheels is driven by the engine and the other is driven by the electric motor is also included in the "electric vehicle" disclosed herein.

While specific examples of the present disclosure have been described above in detail, these examples are merely illustrative and place no limitation on the scope of the patent claims. The technology described in the patent claims also encompasses various changes and modifications to the specific examples described above. The technical elements explained in the present description or drawings provide technical utility either independently or through various combinations. The present disclosure is not limited to the combinations described at the time the claims are filed. Further, the purpose of the examples illustrated by the present description or drawings is to satisfy multiple objectives simultaneously, and satisfying any one of those objectives gives technical utility to the present disclosure.

## Claims

1. An electric vehicle (100, 200, 300) comprising:
an electric motor (110) configured to drive an axle (104);
an inverter (120) comprising a DC terminal (120p, 120n) connected to a battery (109) and AC terminals (120a) connected to stator coils (111) of the electric motor;
a charging terminal (103) connected to a neutral point of the stator coils;
a cooler (130, 330) configured to cool the electric motor; and
a controller(101, 201, 301),
**characterized in that**:
the controller activates the cooler when a main switch (102) for activating the electric motor is on and a temperature of the motor exceeds a threshold temperature after the controller has boosted electric power supplied through the charging terminal with the stator coils and the inverter and charged the battery.

2. The electric vehicle (100, 200, 300) of claim 1, **characterized in that** the controller does not activate the cooler when the temperature of the motor exceeds the threshold temperature but the main switch is off, after the controller has boosted electric power supplied through the charging terminal with the stator coils and the inverter and charged the battery.

3. The electric vehicle (100, 200, 300) of claim 1, **characterized in that** the controller does not activate the cooler when the main switch is on and the temperature of the motor exceeds the threshold temperature but the electric motor disengages from the axle, after the controller has boosted electric power supplied through the charging terminal with the stator coils and the inverter and charged the battery.

4. The electric vehicle (300) of claim 1, **characterized in that**:
gears (308) are disposed between the axle (104) and the electric motor (110),
refrigerant of the cooler (330) serves as lubricant for the gears,
the cooler (330) comprises a selector (335) configured to select one of a full circulation mode and a half circulation mode, wherein the cooler supplies the refrigerant to both of the electric motor and the gears in the full circulation mode, and the cooler supplies the refrigerant to the electric motor but does not supply to the gears in the half circulation mode, and
the controller (301), while cooling the electric motor, activates the cooler in the full circulation mode when the electric motor engages with the gears, whereas the controller activates the cooler in the half circulation mode when the electric motor disengages from the gears.
